# EUROPEAN PATENT APPLICATION

(11) **EP 4 072 014 A1**
(43) Date of publication of application: **12.10.2022**
(21) Application number: 20879698.7
(22) Date of filing: 06.05.2020
(51) Int. Cl.: H03H 9/02, H03H 9/15, H03H 9/17, H03H 9/13

(54) **BULK ACOUSTIC WAVE RESONATOR PROVIDED WITH ELECTRODES HAVING GAP LAYER AND PROTRUDING STRUCTURE, FILTER AND ELECTRONIC DEVICE**

(30) Priority: 23.10.2019 CN 201911009262; 26.10.2019 CN 201911027015
(71) Applicant: ROFS MICROSYSTEM (TIANJIN) CO., LTD., Tianjin 300462 (CN)
(72) Inventor: PANG, Wei, Tianjin 300072 (CN); XU, Yang, Tianjin 300462 (CN); HAO, Long, Tianjin 300072 (CN); YANG, Qingrui, Tianjin 300072 (CN); ZHANG, Menglun, Tianjin 300072 (CN)
(74) Representative: Meyer-Dulheuer MD Legal Patentanwälte PartG mbB
(86) International application number: PCT/CN2020/088665
(87) International publication number: WO 2021/077715

(57) **Abstract**

The present disclosure relates to a bulk acoustic wave resonator, including: a substrate; an acoustic lens; a bottom electrode; a top electrode; and a piezoelectric layer disposed between the bottom electrode and the top electrode, wherein the top electrode, the bottom electrode, the acoustic lens and the piezoelectric layer define an effective region of the resonator in an overlapping region in the thickness direction of the resonator; the top electrode comprises a gap layer, a first top electrode, and a second top electrode, and in the thickness direction of the resonator, the gap layer is formed between the first top electrode and the second top electrode, and the first top electrode forms a surface contact with the piezoelectric layer; and the first top electrode is provided with a protruding structure at the edge of the effective region in the effective region, and the top surface of the protruding structure is higher than the upper surface of the first top electrode in the effective region. The present disclosure further relates to a filter having the foregoing resonator and an electronic device having the filter or the resonator.

## Description

### TECHNICAL FIELD

Embodiments of the present disclosure relate to the field of semiconductors, and in particular, to a bulk acoustic wave resonator, a filter having the resonator, and an electronic device having the resonator or the filter.

### BACKGROUND

Electronic components have been widely used as basic elements of electronic devices, applications of which include mobile phones, vehicles, household appliances and etc. In addition, technologies such as artificial intelligence, Internet of Things and 5G communications that will change the world in the future still need to rely on the electronic components.

The electronic components can exert different characteristics and advantages according to different working principles. Among all electronic components, components that use a piezoelectric effect (or an inverse piezoelectric effect) for working are an important type of electronic components. Piezoelectric devices have very wide applications. A film bulk acoustic resonator (FBAR, also referred to as Bulk Acoustic Wave Resonator, BAW), as an important member of the piezoelectric devices, is important in the field of communications. In particular, FBAR filters have an increasing market in the field of radio frequency (RF) filters. The FBAR has excellent characteristics such as small size, high resonant frequency, high quality factor, large power capacity, and good roll-off effect. The filters of FBAR are gradually replacing traditional surface acoustic wave (SAW) filters and ceramic filters. The filters of FBAR play a huge role in the field of wireless communication radio frequency, and the high sensitivity advantage thereof can be applied to biological, physical, medical and other sensing fields.

The structural main body of the film bulk acoustic wave resonator is a "sandwich" structure composed of electrode-piezoelectric film-electrode, that is, a piezoelectric material is sandwiched between two metal electrode layers. By inputting a sinusoidal signal between the two electrodes, the FBAR converts the input electrical signal into mechanical resonance by the inverse piezoelectric effect, and converts the mechanical resonance into an electrical signal for output by the piezoelectric effect.

The rapid development of communication technologies requires a continuous increase in the working frequency of a filter. For example, the frequency of a 5G communication frequency band (sub-6G) is between 3 GHz and 6 GHz, which is higher than that of 4G and other communication technologies. As for the bulk acoustic wave resonator and the filter, the high working frequency means that the film thickness, especially the film thickness of an electrode, needs to be further reduced. However, a main negative effect caused by the decrease in the film thickness of the electrode is a decrease in a Q value of the resonator resulting from an increase in the electrical loss, especially a decrease in the Q value at a series resonance point and its nearby frequencies. Correspondingly, the performance of a bulk acoustic wave filter with a high working frequency is greatly deteriorated with the decrease in the Q value of the bulk acoustic wave resonator.

### SUMMARY

The present disclosure is provided to alleviate or solve the above problems in the related art.

According to one aspect of embodiments of the present disclosure, a bulk acoustic wave resonator is provided and includes a substrate, an acoustic lens, a bottom electrode, a top electrode, and a piezoelectric layer provided between the bottom electrode and the top electrode. The top electrode, the bottom electrode, the acoustic lens and the piezoelectric layer overlap with each other in a thickness direction of the resonator to form an overlapping region, and the overlapping region defines an effective region of the resonator. The top electrode includes a gap layer, a first top electrode, and a second top electrode. In the thickness direction of the resonator, the gap layer is formed between the first top electrode and the second top electrode, and the first top electrode is arranged in surface contact with the piezoelectric layer. The first top electrode is provided with a protruding structure at an edge of the effective region, and the protruding structure is arranged in the effective region. Atop surface of the protruding structure is located higher than an upper surface of the first top electrode in the effective region.

The present disclosure also proposes a bulk acoustic wave resonator. The bulk acoustic wave resonator includes a substrate, an acoustic lens, a bottom electrode, a top electrode, and a piezoelectric layer provided between the bottom electrode and the top electrode. The top electrode, the bottom electrode, the acoustic lens and the piezoelectric layer overlap with each other in a thickness direction of the resonator to form an overlapping region, and the overlapping region defines an effective region of the resonator. The bottom electrode includes a gap layer, a first bottom electrode, and a second bottom electrode. In the thickness direction of the resonator, the gap layer is formed between the first bottom electrode and the second bottom electrode, and the second bottom electrode is arranged in surface contact with the piezoelectric layer. The second bottom electrode is provided with a protruding structure at an edge of the effective region, and the protruding structure is arranged in the effective region. In the thickness direction of the resonator, a bottom surface of the protruding structure is located below a bottom surface of the second bottom electrode in the effective region.

The embodiments of the present disclosure also relate to a filter including the above bulk acoustic wave resonator.

The embodiments of the present disclosure also relate to an electronic device including the above filter or the above resonator.

### BRIEF DESCRIPTION OF DRAWINGS

The following description and drawings can help understand these and other features and advantages in various embodiments of the present disclosure. The same reference signs in the drawings always indicate the same components.
Fig. 1 is a schematic top view of a bulk acoustic wave resonator according to an exemplary embodiment of the present disclosure.
Fig. 2 is a schematic sectional view alongA1-A2 in Fig. 1 according to an exemplary embodiment of the present disclosure, in which a top electrode is provided with a gap layer.
Fig. 3 is a schematic sectional view along A1-A2 in Fig. 1 according to an exemplary embodiment of the present disclosure, in which a top electrode is provided with a gap layer.
Fig. 4 is a schematic sectional view along A1-A2 in Fig. 1 according to another exemplary embodiment of the present disclosure, in which a top electrode is provided with a gap layer.
Fig. 5 is a schematic sectional view along A1-A2 in Fig. 1 according to another exemplary embodiment of the present disclosure, in which a top electrode is provided with a gap layer.
Fig. 6 is a schematic sectional view along A1-A2 in Fig. 1 according to another exemplary embodiment of the present disclosure, in which a bottom electrode is provided with a gap layer.
Fig. 7 is a schematic sectional view along A1-A2 in Fig. 1 according to another exemplary embodiment of the present disclosure, in which a top electrode is provided with a gap layer.
Fig. 8 is a schematic sectional view along A1-A2 in Fig. 1 according to another exemplary embodiment of the present disclosure, in which a top electrode is provided with a gap layer.
Fig. 9 is a schematic sectional view along A1-A2 in Fig. 1 according to another exemplary embodiment of the present disclosure, in which a top electrode and a bottom electrode are provided with gap layers.
Fig. 10 is a schematic sectional view along A1-A2 in Fig. 1 according to another exemplary embodiment of the present disclosure, in which a top electrode and a bottom electrode are provided with gap layers.

### DESCRIPTION OF EMBODIMENTS

The technical solutions of the present disclosure will be further described in detail below through embodiments and in conjunction with the drawings. In the specification, the same or similar reference signs refer to the same or similar components. The following description of the embodiments of the present disclosure with reference to the drawings is intended to explain the general inventive concept of the present disclosure, and should not be construed as limitation to the present disclosure.

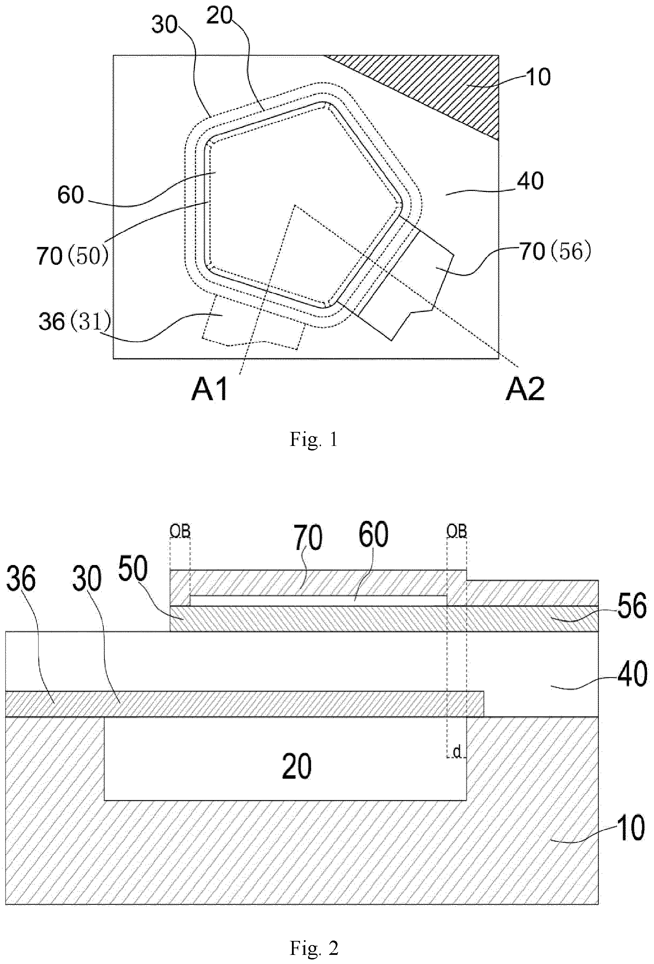

Fig. 1 is a schematic top view of a bulk acoustic wave resonator according to an exemplary embodiment of the present disclosure. In conjunction with other drawings, the reference signs are described as follows:
10: a substrate, which is made of silicon (high-resistance silicon), gallium arsenide, sapphire, quartz or the like;
20: an acoustic lens, which may be a cavity 20, or may employ a Bragg reflection layer or other equivalent forms;
30: a first bottom electrode, which may be made of molybdenum, ruthenium, gold, aluminum, magnesium, tungsten, copper, titanium, iridium, osmium or chromium, or a compound or an alloy thereof;
36: an electrode pin, a material of which is the same as that of the first bottom electrode;
31: a second bottom electrode, a material of which is selected from the same material range as that of the first bottom electrode 30, but the material may not be the same as that of the first bottom electrode 30;
40: a piezoelectric film layer, which may be made of aluminum nitride (AlN), zinc oxide (ZnO), lead zirconate titanate (PZT), lithium niobate (LiNbO₃), quartz, potassium niobate (KNbO₃), lithium tantalate (LiTaO₃) or the like, and may contain rare earth element doped materials with a certain atomic ratio of the above materials;
50: a first top electrode, which may be made of molybdenum, ruthenium, gold, aluminum, magnesium, tungsten, copper, titanium, iridium, osmium or chromium, or a compound or an alloy thereof;
56: an electrode pin, a material of which is the same as that of the first top electrode;
60: an air gap formed in the top electrode and arranged between the first top electrode 50 and a second top electrode 70; and
70: the second top electrode, a material of which is selected from the same material range as that of the first top electrode 50, but the material may not be the same as that of the first top electrode 50.

It should be noted that the air gap forms a gap layer. However, in the present disclosure, the gap layer may be a vacuum gap layer except for an air gap layer, or may be a gap layer filled with other gas medium.

Fig. 2 is a schematic sectional view alongA1-A2 in Fig. 1 according to an exemplary embodiment of the present disclosure, in which a top electrode is provided with a gap layer.

As shown in Fig. 2, the first top electrode 50 and the second top electrode 70 have contact portions at edges thereof. An edge of the first top electrode 50 on a non-pin side thereof is flush with an edge of the second top electrode 70 on a non-pin side thereof, and the contact portion on the non-pin side falls within an effective acoustic range to form a protruding structure. An end point of the contact portion of the first top electrode 50 and the second top electrode 70 on a pin side falls within the effective acoustic region, but the entire contact portion extends toward the pin 56 to outside of the effective acoustic region. Therefore, a range d of the protruding structure on the pin side is determined by the end point of the contact portion within the effective acoustic region and the edge of the acoustic lens.

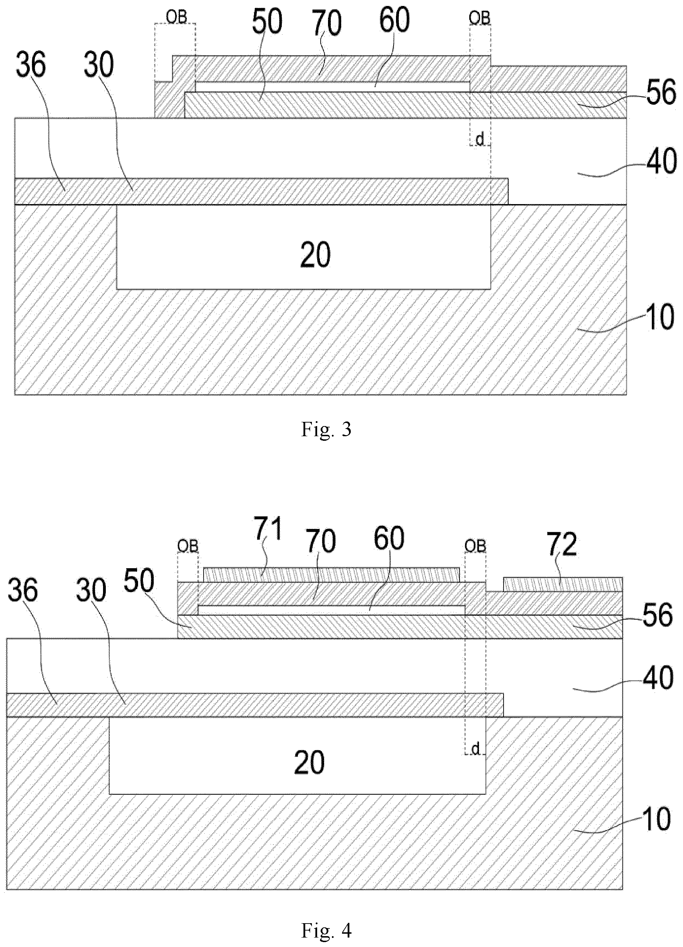

For example, as shown in Fig. 2 and subsequent Fig. 3, at least part of a top surface of the protruding structure is flush with a top surface of the second top electrode 70 in the effective region.

As shown in Fig. 2, subsequent Fig. 3, Fig. 4 and other figures, an outer edge of the protruding structure in a lateral direction of the resonator overlaps with an edge of the effective region. Furthermore, as shown in Fig. 2, the outer edge of the protruding structure in the lateral direction of the resonator overlaps with an edge of a cavity of the acoustic lens.

As shown in Fig. 2 and subsequent Figs. 3-4, the protruding structure is formed by the second top electrode, which generally occurs when the second top electrode is in direct contact with the first top electrode.

As shown in Fig. 2, subsequent Fig. 3 and other figures, the edges of the first top electrode and the second top electrode on non-pin ends are aligned with each other.

Fig. 3 is a schematic sectional view along A1-A2 in Fig. 1 according to an exemplary embodiment of the present disclosure, in which a top electrode is provided with a gap layer.

In Fig. 3, the first top electrode 50 and the second top electrode 70 have contact portions at edges. In addition to contact to each other at the edges, the first top electrode 50 and the second top electrode 70 also extend outwards to an upper surface of the piezoelectric layer 40 and contact with the upper surface of the piezoelectric layer 40. Thus, in the structure of the resonator shown in Fig. 3, the effective acoustic region is determined by the edge of the second top electrode 70 (rather than the first top electrode 50) on the non-pin side and the edge on the pin side of the acoustic lens 20 in the lateral direction. A range of the protruding structure on the non-pin side is determined by an inner end point of the contact portion of the first top electrode 50 and the second top electrode 70 on the non-pin side and an outer end point of a contact portion of the second top electrode 70 and the piezoelectric layer 30.

The end point of the contact portion of the first top electrode 50 and the second top electrode 70 on the pin side falls within the effective acoustic region, but the entire contact portion extends toward the pin 56 to the outside of the effective acoustic region. Therefore, a range d of the protruding structure on the pin side is determined by the end point of the contact portion within the effective acoustic region and the edge of the acoustic lens.

As shown in Fig. 3, the protruding structure on a left side of the top electrode is a step-shaped structure. It should be noted that the step-shaped structure of the present disclosure is not limited to thereto, as long as height changes are provided.

In Fig. 3, the non-pin end of the second top electrode covers a part of the non-pin end of the first top electrode, and is in surface contact with the upper surface of the piezoelectric layer.

Fig. 4 is a schematic sectional view along A1-A2 in Fig. 1 according to another exemplary embodiment of the present disclosure, in which a top electrode is provided with a gap layer and an additional electrode layer 71 is provided on the second top electrode.

The protruding structure used in an actual situation has a height that is in a range of 0.1 times to 2 times a thickness of the first top electrode, but the second top electrode 70 for forming an air gap and reducing impedance has a thickness generally greater than the above range. If the contact portion formed by the excessively thick second top electrode and the first top electrode 50 is directly used as the protruding structure, a serious parasitic mode may be generated, resulting in deterioration of the performance of the resonator. To solve this problem, as the structure shown in Fig. 4, a layer of thin second top electrode 70 is formed to meet the thickness requirements of the protruding structure at first, and additional electrode layers 71 and 72 are then deposited on a surface of the second top electrode 70. It is ensured that the protruding structure is not covered by the additional electrode layers 71 and 72 through a patterning process. The above structure can not only ensure that the thickness of the protruding structure meets acoustic requirements, but also ensure that the electrodes outside the region of the protruding structure meet electrical impedance requirements and rigidity requirements.

As shown in Fig. 4, in the lateral direction of the resonator, the additional electrode layer 71 is arranged between a first protruding structure (OB) and a second protruding structure (OB).

In a further embodiment, for example, the additional electrode layer 71 has a thickness in a range of 200 Å to 10000 Å, as shown in Fig. 4.

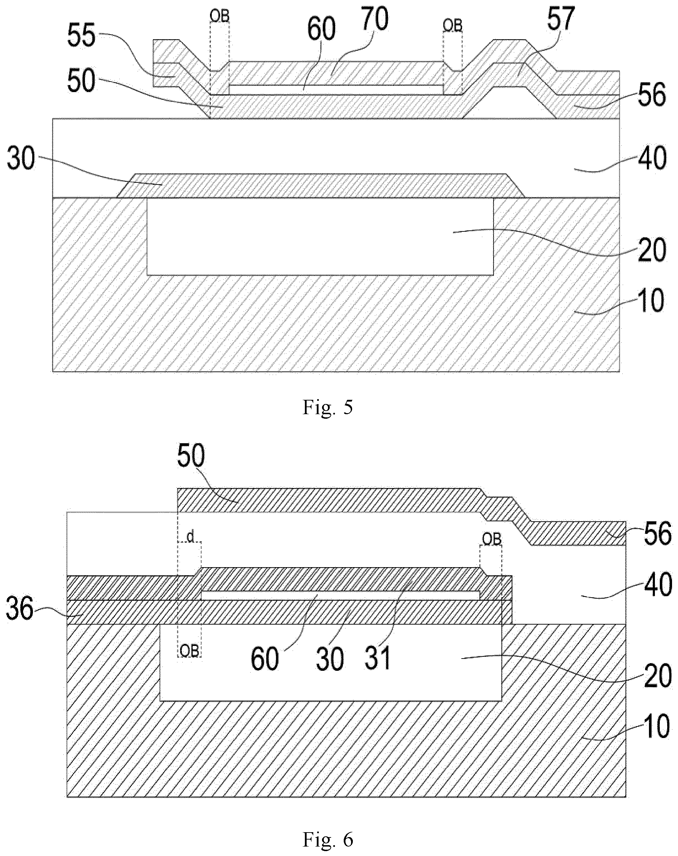

Fig. 5 is a schematic sectional view along A1-A2 in Fig. 1 according to another exemplary embodiment of the present disclosure, in which a top electrode is provided with a gap layer.

As shown in Fig. 5, in addition to an air gap structure 60, the first top electrode is also provided with a wing structure 55. Since a lateral boundary of the effective acoustic region of the resonator is determined by a starting point of a lower surface of the wing structure above the piezoelectric layer 40, the range of the protruding structure in this structure is determined by two end points of the air gap structure 60 and the lateral boundary of the effective region.

As shown in Fig. 5, the first top electrode is further provided with a bridge structure 57. The range of the protruding structure close to the bridge structure may be determined similar to the range of the protruding structure close to the wing structure.

Fig. 6 is a schematic sectional view along A1-A2 in Fig. 1 according to another exemplary embodiment of the present disclosure, in which a bottom electrode is provided with a gap layer.

In Fig. 6, since the edge of the top electrode 50 on the non-pin side is located within the edge of the acoustic lens 20, a left side boundary of the effective region is determined by the edge of the top electrode 50. Further, the edges of the first and second bottom electrodes on the non-pin side both extend beyond the acoustic lens 20, such that the boundary of the effective region on the non-pin side of the bottom electrode is determined by the boundary of the acoustic lens. Therefore, the range of the protruding structure of the resonator in Fig. 6 is determined by two end points of the air gap 60, the edge of the top electrode 50 on the non-pin side, and the edge of the acoustic lens 20 on the non-pin side of the bottom electrode.

Accordingly, in Fig. 6, the bottom electrode includes a gap layer, a first bottom electrode, and a second bottom electrode. In the thickness direction of the resonator, the gap layer is formed between the first bottom electrode and the second bottom electrode, and the second bottom electrode is in surface contact with the piezoelectric layer. The second bottom electrode is provided with a protruding structure at an edge of the effective region in the effective region, and in the thickness direction of the resonator, a bottom surface of the protruding structure is located below the bottom surface of the second bottom electrode in the effective region.

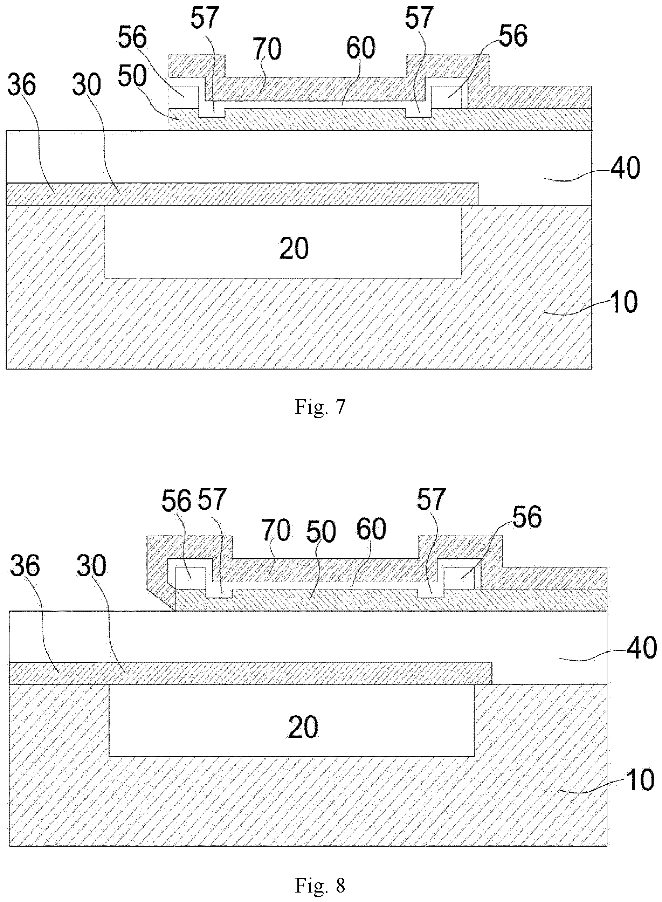

Fig. 7 is a schematic sectional view along A1-A2 in Fig. 1 according to another exemplary embodiment of the present disclosure, in which a top electrode is provided with a gap layer.

In Fig. 7, the second top electrode 70 is attached to a conventional resonator structure. The first top electrode 50 has acoustic structures, i.e. protrusions 56 and recesses 57. The second top electrode 70, the protrusions 56, the recesses 57 and the first top electrode 50 form an air gap 60, and an end point of the air gap 60 on the pin side falls outside the effective region. As shown in Fig. 7, a gap layer is provided between the first top electrode and the second top electrode, and the second top electrode is spaced apart from the acoustic structure on the first top electrode in the thickness direction.

Fig. 8 is a schematic sectional view along A1-A2 in Fig. 1 according to another exemplary embodiment of the present disclosure, in which a top electrode is provided with a gap layer.

In Fig. 8, the edge position of the second top electrode 70 in Fig. 7 is changed, and the electrical connection relationship between the second top electrode 70 and the second top electrode 50 is changed. For example, as shown in Fig. 8, the second top electrode 70 extends to the outside of the first top electrode 50 and the protrusions 56 on the non-pin side, and is electrically connected to the first top electrode 50 instead of hanging. Obviously, the edge of the second top electrode 70 is not limited to extend outwards, but also may retract inwardly to be within a lateral range of the first top electrode 50.

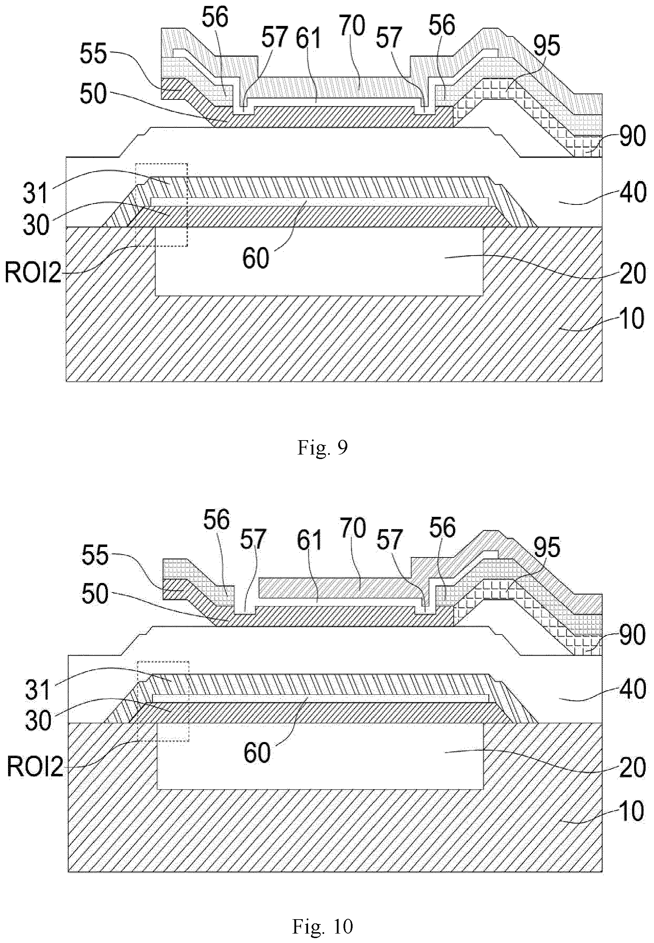

Fig. 9 is a schematic sectional view along A1-A2 in Fig. 1 according to another exemplary embodiment of the present disclosure, in which a top electrode and a bottom electrode are provided with gap layers, and the top electrode is provided with a wing structure and a bridge structure.

A wing structure 55, a bridge structure 95 and an air gap 60 of the bottom electrode are provided in Fig. 9 on the basis of Fig. 7. The second top electrode 70 is in contact with the protruding structures 56 located on a horizontal portion of the wing structure. In this way, end points of an air gap 61 of the top electrode extend above the horizontal portion of the wing structure, meanwhile end points of the air gap 60 of the bottom electrode extend to the outside of the boundary of the acoustic lens 20. In Fig. 9, a top surface of the wing structure and a top surface of the bridge structure are provided with protruding layer structures, and a part of the protruding layer structure that is in contact with the first top electrode in the effective region forms the protruding structures 56.

Fig. 10 is a schematic sectional view along A1-A2 in Fig. 1 according to another exemplary embodiment of the present disclosure, in which a top electrode and a bottom electrode are provided with gap layers, and the top electrode is provided with a wing structure and a bridge structure.

The edge of the second top electrode 70 on the non-pin side is not necessarily aligned with the edge of the first top electrode 50 on the same side. For example, in Fig. 10, the edge of the second top electrode 70 on the non-pin side retracts inwardly to be within the lateral range of the effective region or the inside of the recess structures 57. Obviously, the edge of the second top electrode 70 may extend to the outside of the horizontal portion of the wing structure 55 and keep in contact with a left end of the wing structure 55, or to be hanged in the air, which all fall within the scope of the present disclosure.

In the present disclosure, the height of the protruding structure may be in a range of 0.1 times to 2 times the thickness of the first top electrode.

In the present disclosure, a mentioned numerical range may not only be endpoint values, but may also be a mean value of the endpoint values or other values, which are all within the protection scope of the present disclosure.

In the present disclosure, an "inner side" and "outer side" of a component are determined by which part of the component is closer to a center of the active region of the resonator in the transverse direction of the resonator. If a side is close to the center of the active region of the resonator, it is the inner side. Instead, if a side is far away from the center of the active region of the resonator, it is the outer side.

As can be appreciated by those skilled in the art, the bulk acoustic wave resonator according to the present disclosure can be used to form a filter.

Based on the above description and in conjunction with the drawings of the present disclosure, the present disclosure provides the following technical solutions:
1. A bulk acoustic wave resonator includes:
   a substrate;
   an acoustic lens;
   a bottom electrode;
   a top electrode; and
   a piezoelectric layer provided between the bottom electrode and the top electrode, wherein
   the top electrode, the bottom electrode, the acoustic lens and the piezoelectric layer overlap with each other in a thickness direction of the resonator to form an overlapping region, and the overlapping region defines an effective region of the resonator;
   the top electrode includes a gap layer, a first top electrode, and a second top electrode, and in the thickness direction of the resonator, the gap layer is formed between the first top electrode and the second top electrode, and the first top electrode is arranged to be in surface contact with the piezoelectric layer; and
   the first top electrode is provided with a protruding structure at an edge of the effective region, the protruding structure is arranged in the effective region, and a top surface of the protruding structure is located higher than an upper surface of the first top electrode in the effective region.
2. The resonator according to 1, wherein
   the protruding structure has a height, which is in a range of 0.1 times to 2 times a thickness of the first top electrode.
3. The resonator according to 1, wherein
   at least part of the top surface of the protruding structure is flush with a top surface of the second top electrode in the effective region.
4. The resonator according to 1, wherein
   an outer edge of the protruding structure in a lateral direction of the resonator overlaps with the edge of the effective region.
5. The resonator according to 1, wherein
   the protruding structure is formed by the second top electrode.
6. The resonator according to any one of 1-4, wherein
   the first top electrode and the second top electrode are electrically connected to each other on a non-pin end of the top electrode; and
   the protruding structure includes a first protrusion and a second protrusion, the first protrusion is formed by the first top electrode and the second top electrode on a pin end of the top electrode, and the second protrusion is formed by the first top electrode and the second top electrode on the non-pin end of the top electrode.
7. The resonator according to 6, wherein
   edges of the first top electrode and the second top electrode on the non-pin end are aligned with each other.
8. The resonator according to 6, wherein
   a non-pin end of the second top electrode partially covers a part of a non-pin end of the first top electrode, and is arranged in surface contact with an upper surface of the piezoelectric layer.
9. The resonator according to 8, wherein
   the second protrusion is a step-shaped protruding structure.
10. The resonator according to 6, wherein
   the second top electrode is provided with an additional electrode layer attached to an upper surface thereof, and in a lateral direction of the resonator, the additional electrode layer is arranged between the first protrusion and the second protrusion.
11. The resonator according to 10, wherein
   the additional electrode layer has a thickness in a range of 200 Å to 10000 Å, and the protruding structure has a height that is in a range of 0.1 times to 2 times a thickness of the first top electrode.
12. The resonator according to 6, wherein
   the first top electrode is provided with a bridge structure on the pin end, the first top electrode is provided with a wing structure on the non-pin end, and the bridge structure and the wing structure define a boundary of the effective region; and
   the wing structure is provided with a protruding layer structure on a top surface thereof, the bridge structure is provided with a protruding layer structure on a top surface thereof, and a portion of the protruding layer structures that is in contact with the first top electrode in the effective region forms the protruding structure.
13. The resonator according to 12, wherein
   the gap layer is arranged between the first protrusion and the second protrusion in a lateral direction of the resonator.
14. The resonator according to 12, wherein
   the gap layer extends to at least part of the top surface of the bridge structure.
15. The resonator according to 14, wherein
   a non-pin end of the second top electrode is spaced apart from the wing structure in a lateral direction of the resonator, and is spaced apart from the first top electrode in the thickness direction of the resonator.
16. The resonator according to 14, wherein
   the gap layer extends to at least part of the top surface of the wing structure and at least part of the top surface of the bridge structure.
17. The resonator according to any one of 12-16, wherein
   the first top electrode is provided with a concave structure on an inner side of the protruding structure, and the concave structure is arranged adjacent to the protruding structure.
18. The resonator according to 6, wherein
   an outer edge of the first protrusion is flush with an edge of the acoustic lens or extends outwardly beyond the edge of the acoustic lens.
19. The resonator according to any one of 1-4, wherein
   the first top electrode and the second top electrode are spaced apart from each other on a non-pin end of the top electrode;
   the protruding structure includes a first protrusion formed on a pin end of the first top electrode and a second protrusion formed on a non-pin end of the first top electrode; and
   the second top electrode is spaced apart from the protruding structure in the thickness direction of the resonator.
20. The resonator according to 19, wherein
   the first top electrode is provided with a concave structure on an inner side of the protruding structure, and the concave structure is arranged adjacent to the protruding structure.
21. The resonator according to 19 or 20, wherein
   a non-pin end of the second top electrode surrounds the second protrusion, and is connected to an end surface of the non-pin end of the first top electrode.
22. The resonator according to 21, wherein
   the non-pin end of the second top electrode is connected to the end surface of the non-pin end of the first top electrode, and is not in contact with a top surface of the piezoelectric layer.
23. A bulk acoustic wave resonator includes:
   a substrate;
   an acoustic lens;
   a bottom electrode;
   a top electrode; and
   a piezoelectric layer provided between the bottom electrode and the top electrode, wherein
   the top electrode, the bottom electrode, the acoustic lens and the piezoelectric layer overlap with each other in a thickness direction of the resonator to form an overlapping region, and the overlapping region defines an effective region of the resonator;
   the bottom electrode includes a gap layer, a first bottom electrode, and a second bottom electrode, and in the thickness direction of the resonator, the gap layer is formed between the first bottom electrode and the second bottom electrode, and the second bottom electrode is arranged in surface contact with the piezoelectric layer; and
   the second bottom electrode is provided with a protruding structure at an edge of the effective region, the protruding structure is arranged in the effective region, and in the thickness direction of the resonator, a bottom surface of the protruding structure is located below a bottom surface of the second bottom electrode in the effective region.
24. The resonator according to 23, wherein
   the protruding structure includes a first protrusion formed on a pin end of the first bottom electrode and a second protrusion formed on a non-pin end of the first bottom electrode;
   an outer edge of the first protrusion is flush with an edge of the acoustic lens or extends outwardly beyond the edge of the acoustic lens; and
   an outer edge of the second protrusion is flush with an end surface of a non-pin end of the top electrode, and the non-pin end of the top electrode is arranged in direct surface contact with the piezoelectric layer.
25. A filter includes the bulk acoustic wave resonator according to any one of 1-24.
26. An electronic device includes the filter according to 25 or the resonator according to any one of 1-24.

Although the embodiments of the present disclosure have been shown and described, it will be understood by those skilled in the art that changes can be made to these embodiments without departing from the principles and spirit of the present disclosure, and the scope of the present disclosure is determined by the appended claims and their equivalents.

## Claims

1. A bulk acoustic wave resonator, comprising:
a substrate;
an acoustic lens;
a bottom electrode;
a top electrode; and
a piezoelectric layer provided between the bottom electrode and the top electrode,
wherein the top electrode, the bottom electrode, the acoustic lens and the piezoelectric layer overlap with each other in a thickness direction of the resonator to form an overlapping region, and the overlapping region defines an effective region of the resonator;
wherein the top electrode comprises a gap layer, a first top electrode, and a second top electrode, and in the thickness direction of the resonator, the gap layer is formed between the first top electrode and the second top electrode, and the first top electrode is arranged in surface contact with the piezoelectric layer; and
wherein the first top electrode is provided with a protruding structure at an edge of the effective region, the protruding structure is arranged in the effective region, and a top surface of the protruding structure is located higher than an upper surface of the first top electrode in the effective region.

2. The resonator according to claim 1, wherein the protruding structure has a height, which is in a range of 0.1 times to 2 times a thickness of the first top electrode.

3. The resonator according to claim 1, wherein at least part of the top surface of the protruding structure is flush with a top surface of the second top electrode in the effective region.

4. The resonator according to claim 1, wherein an outer edge of the protruding structure in a lateral direction of the resonator overlaps with the edge of the effective region.

5. The resonator according to claim 1, wherein the protruding structure is formed by the second top electrode.

6. The resonator according to any one of claims 1-4, wherein the first top electrode and the second top electrode are electrically connected to each other on a non-pin end of the top electrode; and
the protruding structure comprises a first protrusion and a second protrusion, the first protrusion is formed by the first top electrode and the second top electrode on a pin end of the top electrode, and the second protrusion is formed by the first top electrode and the second top electrode on the non-pin end of the top electrode.

7. The resonator according to claim 6, wherein edges of the first top electrode and the second top electrode on the non-pin end are aligned with each other.

8. The resonator according to claim 6, wherein a non-pin end of the second top electrode partially covers a part of a non-pin end of the first top electrode, and is arranged in surface contact with an upper surface of the piezoelectric layer.

9. The resonator according to claim 8, wherein the second protrusion is a step-shaped protruding structure.

10. The resonator according to claim 6, wherein the second top electrode is provided with an additional electrode layer attached to an upper surface thereof, and in a lateral direction of the resonator, the additional electrode layer is arranged between the first protrusion and the second protrusion.

11. The resonator according to claim 10, wherein the additional electrode layer has a thickness in a range of 200 Å to 10000 Å, and the protruding structure has a height that is in a range of 0.1 times to 2 times a thickness of the first top electrode.

12. The resonator according to claim 6, wherein the first top electrode is provided with a bridge structure on the pin end, the first top electrode is provided with a wing structure on the non-pin end, and the bridge structure and the wing structure define a boundary of the effective region; and
the wing structure is provided with a protruding layer structure on a top surface thereof, the bridge structure is provided with a protruding layer structure on a top surface thereof, and a portion of the protruding layer structures that is in contact with the first top electrode in the effective region forms the protruding structure.

13. The resonator according to claim 12, wherein the gap layer is provided between the first protrusion and the second protrusion in a lateral direction of the resonator.

14. The resonator according to claim 12, wherein the gap layer extends to at least part of the top surface of the bridge structure.

15. The resonator according to claim 14, wherein a non-pin end of the second top electrode is spaced apart from the wing structure in a lateral direction of the resonator, and is spaced apart from the first top electrode in the thickness direction of the resonator.

16. The resonator according to claim 14, wherein the gap layer extends to at least part of the top surface of the wing structure and at least part of the top surface of the bridge structure.

17. The resonator according to any one of claims 12-16, wherein the first top electrode is provided with a concave structure on an inner side of the protruding structure, and the concave structure is arranged adjacent to the protruding structure.

18. The resonator according to claim 6, wherein an outer edge of the first protrusion is flush with an edge of the acoustic lens or extends outwardly beyond the edge of the acoustic lens.

19. The resonator according to any one of claims 1-4, wherein the first top electrode and the second top electrode are spaced apart from each other on a non-pin end of the top electrode;
the protruding structure comprises a first protrusion formed on a pin end of the first top electrode and a second protrusion formed on a non-pin end of the first top electrode; and
the second top electrode is spaced apart from the protruding structure in the thickness direction of the resonator.

20. The resonator according to claim 19, wherein the first top electrode is provided with a concave structure on an inner side of the protruding structure, and the concave structure is arranged adjacent to the protruding structure.

21. The resonator according to claim 19 or 20, wherein a non-pin end of the second top electrode surrounds the second protrusion, and is connected to an end surface of the non-pin end of the first top electrode.

22. The resonator according to claim 21, wherein the non-pin end of the second top electrode is connected to the end surface of the non-pin end of the first top electrode, and is not in contact with a top surface of the piezoelectric layer.

23. A bulk acoustic wave resonator, comprising:
a substrate;
an acoustic lens;
a bottom electrode;
a top electrode; and
a piezoelectric layer provided between the bottom electrode and the top electrode,
wherein the top electrode, the bottom electrode, the acoustic lens and the piezoelectric layer overlap with each other in a thickness direction of the resonator to form an overlapping region, and the overlapping region defines an effective region of the resonator;
wherein the bottom electrode comprises a gap layer, a first bottom electrode, and a second bottom electrode, and in the thickness direction of the resonator, the gap layer is formed between the first bottom electrode and the second bottom electrode, and the second bottom electrode is arranged in surface contact with the piezoelectric layer; and
wherein the second bottom electrode is provided with a protruding structure at an edge of the effective region, the protruding structure is arranged in the effective region, and in the thickness direction of the resonator, a bottom surface of the protruding structure is located below a bottom surface of the second bottom electrode in the effective region.

24. The resonator according to claim 23, wherein the protruding structure comprises a first protrusion formed on a pin end of the first bottom electrode and a second protrusion formed on a non-pin end of the first bottom electrode;
an outer edge of the first protrusion is flush with an edge of the acoustic lens or extends outwardly beyond the edge of the acoustic lens; and
an outer edge of the second protrusion is flush with an end surface of a non-pin end of the top electrode, and the non-pin end of the top electrode is arranged in direct surface contact with the piezoelectric layer.

25. A filter, comprising the bulk acoustic wave resonator according to any one of claims 1-24.

26. An electronic device, comprising the filter according to claim 25 or the resonator according to any one of claims 1-24.
